# EUROPÄISCHE PATENTSCHRIFT

(11) **EP 1 269 580 B1**
(45) Veröffentlichungstag und Bekanntmachung des Hinweises auf die Patenterteilung: **09.02.2011**
(21) Anmeldenummer: 01919419.0
(22) Anmeldetag: 03.04.2001
(51) Int. Cl.: H01R 13/514

(54) **ELEKTRONISCHE BAUGRUPPE**
ELECTRONIC MODULE
MODULE ELECTRONIQUE

(30) Priorität: 07.04.2000 DE 10017335
(43) Veröffentlichungstag der Anmeldung: 02.01.2003
(73) Patentinhaber: Conti Temic microelectronic GmbH, 90411 Nürnberg (DE)
(72) Erfinder: HALLITSCHKE, Frank, 85134 Stammham (DE); SCHNEIDER, Johann, 85139 Wettstetten (DE)
(86) Internationale Anmeldenummer: PCT/EP2001/003741
(87) Internationale Veröffentlichungsnummer: WO 2001/078197

(56) Entgegenhaltungen:
- EP-A- 0 153 632
- EP-A- 0 834 966
- EP-A- 0 923 172
- US-A- 4 703 397

## Beschreibung

In vielen Bereichen werden elektronische Baugruppen für unterschiedliche Anwendungen und Aufgaben eingesetzt; beispielsweise sind im Kraftfahrzeugbereich elektronische Baugruppen als Steuergeräte (bsp. als Motorsteuergeräte oder als Türsteuergeräte) zur Verarbeitung der Meßsignale von Sensoren und der Ausgangssignale von Aktoren sowie zur Steuerung verschiedener Aggregatefunktionen oder Komponenten des Kraftfahrzeugs vorgesehen oder als Sicherungs- und Relaisboxen im Einsatz.

Elektronische Baugruppen bestehen üblicherweise aus einem Schaltungsträger (beispielsweise einer Leiterplatte) und einer auf diesem Schaltungsträger angeordneten Schaltungsanordnung bestehend aus (bsp. durch Lötmontage oder Klebemontage aufgebrachten) Bauelementen und Kontaktierungselementen (bsp. unter Verwendung der Einpreßtechnik realisierte, senkrecht zum Schaltungsträger abstehende Einpreßkontakte). Zum Schutz gegen Umwelteinflüsse wird die Schaltungsanordnung von einem Gehäuse umschlossen. Damit die im Gehäuse untergebrachte Schaltungsanordnung kontaktiert werden kann, ist im Gehäuse mindestens eine Steckerbuchse integriert. Jede der Steckerbuchsen weist eine bestimmte Anzahl von Öffnungen - sogenannte Pindurchbrüche - auf. Die auf dem Schaltungsträger angeordneten Kontaktierungselemente sind so positioniert, daß jeweils ein Kontaktierungselement mittig durch einen korrespondierenden Pindurchbruch einer Steckerbuchse nach außen geführt wird. Die Kontaktierungselemente einer Steckerbuchse können über einen zur Steckerbuchse passenden Anschlußstecker kontaktiert werden.

Aufgrund von Fertigungstoleranzen, unterschiedlicher thermischer Ausdehnung und den hygroskopischen Eigenschaften (Wasseraufnahme bzw. Feuchtigkeitsaufnahme) des Gehäuses und des Schaltungsträgers ist die (genaue) Positionierung der Kontaktierungselemente bezüglich der Pindurchbrüche der Steckerbuchsen vor allem bei großen Gehäuseabmessungen und bei einer Vielzahl von im Gehäuse integrierten Steckerbuchsen problematisch. Bei der Verwendung von Einpreßkontakten als Kontaktierungselemente gelten darüber hinaus besonders hohe Anforderungen an die zentrische Positionierung der einzelnen Kontaktierungselemente bezüglich der Pindurchbrüche der entsprechenden Steckerbuchse.

Aus der US 4 703 379 ist eine Schaltungsanordnung bekannt, die einen Hauptanschlußblock und einen von dem Hauptanschlußblock lösbaren Unteranschlußblock umfasst. Eine einstückige Flachleiterverbindung wird als Anschlußpol vorgesehen, die auf der einen Seite vom Hauptanschlußblock durch den Unteranschlußblock hindurchverläuft und auf der anderen Seite einen Steckanschluß bildet.

Aus der EP 0 834 966 A2 ist eine Steckverbindung für eine unterhalb einer Abdeckung befindlichen Baugruppe bekannt. Es ist vorgesehen, dass die Kontaktstücke der auf der abnehmbaren Abdeckung zu realisierenden Steckverbindung direkt auf der unterhalb der demontierbaren Abdeckung befindlichen Baugruppe in einer derartigen Länge angeordnet sind, so dass diese Kontaktstücke beim Aufsetzen der Abdeckung nebst dem darauf befindlichen Isolierteil durch entsprechend der Anzahl der Kontaktstücke der Baugruppe im Isolierteil angeordneten Öffnungen hindurchführbar sind und somit im montierten Zustand insgesamt die auf der Abdeckung befindliche Steckverbindung ergeben.

Aus der EP 0 923 172 A2 ist eine Anordnung betreffend eine elektrische und/oder elektronische Bauelemente tragende Elektrikplatte mit einem elektrischen Steckverbinder bekannt, bei der eine die Elektrikplatte bedeckenden Abdeckung, welche Elektrikplatte unterhalb der Abdeckung angeordnet ist und welcher Steckverbinder zur Herstellung einer elektrischen Verbindung zwischen der Elektrikplatte zugeordneten Leiterbahnen und einer Anschlußleitung vorgesehen ist.

Ferner ist aus der EP 0 153 632 eine elektronische Baugruppe mit auf einem Schaltungsträger umgebenden Gehäuse und mindestens einem in einem Gehäuse integrierten Steckeranschluß bekannt. Die elektronische Baugruppe umfasst ferner ein Einsatzteil mit Pindurchbrüchen welches in einer Aussparung des Gehäuses beweglich gelagert ist. Die Pindurchbrüche sind bezüglich der Kontaktierungselemente ausrichtbar.

Der Erfindung liegt die Aufgabe zugrunde, eine elektronische Baugruppe anzugeben, die insbesondere einen einfachen Aufbau und geringe Kosten, eine hohe Zuverlässigkeit und eine vereinfachte Fertigung sowie vorteilhafte Eigenschaften bezüglich der Positionierung der Kontaktierungselemente zu den Pindurchbrüchen der Stekkerbuchsen und der Belastung bei der Kontaktierung mit dem externen Anschlußstecker aufweist.

Diese Aufgabe wird erfindungsgemäß durch die Merkmale des Patentanspruchs 1 gelöst. Vorteilhafte Ausgestaltungen der elektronischen Baugruppe sind Bestandteil der weiteren Patentansprüche.

Bei der vorgestellten elektronischen Baugruppe wird mindestens eine Steckerbuchse vom Gehäuse der elektronischen Baugruppe entkoppelt (schwimmend bzw. Beweglich im Gehäuse der elektronischen Baugruppe gelagert), so dass die Pindurchbrüche der Steckerbuchsen nach dem Schaltungsträger bzw. den auf dem Schaltungsträger angeordneten Kontaktierungselementen ausgerichtet werden können und damit genau positionierbar sind. Darüber hinaus können mehrere Steckerbuchsen zu einer Steckerbuchsengruppe zusammengefasst werden und in ihrer Gesamtheit vom Gehäuse der elektronischen Baugruppe entkoppelt werden (schwimmend bzw. beweglich im Gehäuse der elektronischen Baugruppe gelagert werden). Die Anzahl der Steckerbuchsen einer Steckerbuchsengruppe ist frei wählbar. Zweckmäßigerweise werden zur Bildung einer Steckerbuchsengruppe benachbarte Steckerbuchsen zusammengefasst, um die Absolutabmessungen der entstehenden Steckerbuchsengruppe klein zu halten.

Das die Schaltungsanordnung umschließende Gehäuse kann bsp. aus mehreren Gehäuseteilen zusammengesetzt sein, bsp. aus den beiden Gehäuseteilen Gehäuseoberteil und Gehäuseunterteil. Hierbei kann die Steckerbuchse oder die Steckerbuchsengruppe vom zugehörigen Gehäuseteil der elektronischen Baugruppe entkoppelt werden (schwimmend bzw. beweglich im zugehörigen Gehäuseteil der elektronischen Baugruppe gelagert werden).

Durch die Entkopplung spielen Toleranzprobleme nur innerhalb einer Steckerbuchse bzw. einer Steckerbuchsengruppe eine Rolle, d.h. nur innerhalb der Abmessungen der vom Gehäuse entkoppelten Steckerbuchse bzw. Steckerbuchsengruppe (diese sind signifikant kleiner als die Abmessungen des Gehäuses bzw. des Gehäuseteils der elektronischen Baugruppe).

Zur Entkopplung der Steckerbuchse bzw. Steckerbuchsengruppe vom Gehäuse bzw. zugehörigen Gehäuseteil der elektronischen Baugruppe wird die Steckerbuchse bzw. Steckerbuchsengruppe als separates Einsatzteil ausgeführt. Im Gehäuse und insbesondere im zugehörigen Gehäuseteil befindet sich eine zum Einsatzteil korrespondierende Aussparung, so daß das Einsatzteil und das Gehäuse bzw. zugehörige Gehäuseteil miteinander gefügt werden können. Die Verbindung von Einsatzteil und Gehäuse bzw. Gehäuseteil erfolgt durch Formschluß von an der Umrandung des Einsatzteils vorgesehenen Befestigungselementen mit auf der Innenseite des Gehäuses bzw. Gehäuseteils vorgesehenen, die Aussparung umgebenden zugehörigen Verbindungselementen. Nach dem Fügen von Einsatzteil und Gehäuse bzw. Gehäuseteil ist das Einsatzteil in einer Ebene (also in zwei Richtungen) beweglich in der Aussparung des Gehäuses bzw. Gehäuseteils gelagert, senkrecht zu dieser Ebene über den Formschluß nahezu spielfrei gelagert. Durch das Zusammenspiel einer an der Umrandung der Aussparung angebrachten (in der Art eines Kragens ausgebildeten) Ausformung mit einer an der Umrandung des Einsatzteils gefertigten Nut wird die im Gehäuse bzw. Gehäuseteil vorhandene Aussparung beim Fügen von Einsatzteil und Gehäuse bzw. Gehäuseteil staubdicht verschlossen. Indem die Breite der Nut des Einsatzteils größer als die Breite der Ausformung (des Kragens) des Gehäuses bzw. Gehäuseteils ausgeführt wird, ist die Beweglichkeit des Einsatzteils in der Ebene einerseits gewährleistet und wird andererseits gleichzeitig begrenzt. Die Ausrichtung des Einsatzteils und damit der Pindurchbrüche der Steckerbuchsen bzw. cer Steckerbuchsengruppe bezüglich der Kontaktierungselemente auf dem Schaltungsträger erfolgt bei der Montage des Schaltungsträgers mit dem Verbund aus Gehäuse bzw. Gehauseteil und Einsatzteil. Dabei greifen am Einsatzteil befindliche Zentrierstifte in Aufnahmebohrungen des Schaltungsträgers und richten das Einsatzteil lokal zu den Kontaktierungselementen aus.

Die Anzahl der Verbindungselemente des Gehäuses bzw. Gehäuseteils und damit die Anzahl der korrespondierenden Befestigungselemente des Einsatzteils wird in Abhängigkeit von der Größe des Einsatzteils (der Aussparung im Gehäuse bzw. Gehäuseteil) und damit der Größe der Steckerbuchse bzw. Steckerbuchsengruppe sowie in Abhängigkeit von den bei der Verbindung von Einsatzteil und Gehäuse bzw. Gehäuseteil bzw. beim Anbringen der externen Anschlußstecker an die Steckeranschlüsse bzw. Steckerbuchsen übertagenen Kräften gewählt.

Das Einsatzteil kann zusammen mit dem Gehäuse bzw. zugehörigen Gehäuseteil in einem gemeinsamen Fertigungsschritt hergestellt werden. Insbesondere kann das Einsatzteil bei einem aus Kunststoff bestehenden, aus mindestens zwei Gehäuseteilen zusammengesetzten Gehäuse zusammen mit dem zugehörigen Gehäuseteil in einem Spritzgußprozeß unter Verwendung eines (gemeinsamen) Familienwerkzeugs hergestellt werden, so daß eine genaue Vormontage von Gehäuseteil und Einsatzteil möglich ist und damit logistisch für die Endfertigung (Montage des Schaltungsträgers mit dem kompletten Gehäuse) nur das vormontierte Teil gehandhabt werden muß.

Die vorgestellte elektronische Baugruppe vereinigt mehrere Vorteile in sich:
- Aufgrund des modularen Aufbaus kann eine Standardisierung (Baukastensystem) erreicht werden. Durch die Integration der Steckerbuchsen und insbesondere durch Integration der durch Zusammenfassung mehrerer Steckerbuchsen gebildeten Steckerbuchsengruppe in einem Einsatzteil mit gegenüber den Gehäusemaßen kleinen Abmessungen, werden die fixen Funktionsmaße zur Einhaltung der in den Ausführungsvorschriften festgelegten Toleranzen kleiner, wobei bei Kunststoffgehäusen die Wiederholgenauigkeit von Spritzgußprozessen bei der Herstellung des Einsatzteils genutzt werden kann, indem die Aufnahmebohrungen im Schaltungsträger an die vermessenen werkzeugfallenden Teile adaptiert werden. Durch eine hinterschnittfreie Realisierung der Entkopplung der Steckerbuchsen bzw. Steckerbuchsengruppe im Gehäuseteil und im Einsatzteil werden bei mittels Spritzgußprozessen hergestellten Kunststoffgehäusen keine (kosten verursachenden) beweglichen Schieber im Spritzgußwerkzeug benötigt: dadurch sind die Hersteilungskosten des Spritzgußwerkzeugs geringer, ergeben sich bei der Herstellung kleine Taktzeiten und hohe Werkzeugstandzeiten und somit auch geringe Teilepreise und es tritt auch keine Verschmutzung der Spritzgußteile (Gehäuseteil, Einsatzteil) durch die bei beweglichen Schiebern benötigten Schmierstoffe auf (ökonomischer und ökologischer Nutzen) auf.
- Die Montage des Einsatzteils mit dem Gehäuse bzw. Gehäuseteil nach dem Spritzgußprozeß ist auf einfache Weise automatisierbar, wobei unter Verwendung von im Gehäuse bzw. Gehäuseteil angebrachten Einführhilfen eine Positionierung des Einsatzteils ermöglicht wird; durch die sichere und stabile Befestigung des Einsatzteils im Gehäuse bzw. Gehäuseteil und durch die Abdichtung gegen äußere Einflüsse (insbesondere gegenüber eintretenden Staub) werden trotz der beschriebenen Entkopplung keine zusätzlichen Befestigungselemente oder Dichtelemente benötigt. Aufgrund der Vorspannung zwischen den Befestigungselementen des Einsatzteils und den zugehörigen Verbindungselementen des Gehäuses bzw. Gehäuseteils nach der Montage des Einsatzteils mit dem Gehäuse bzw. Gehäuseteil wird ein Klappern des Einsatzteils im Gehäuse bzw. Gehäuseteil verhindert.

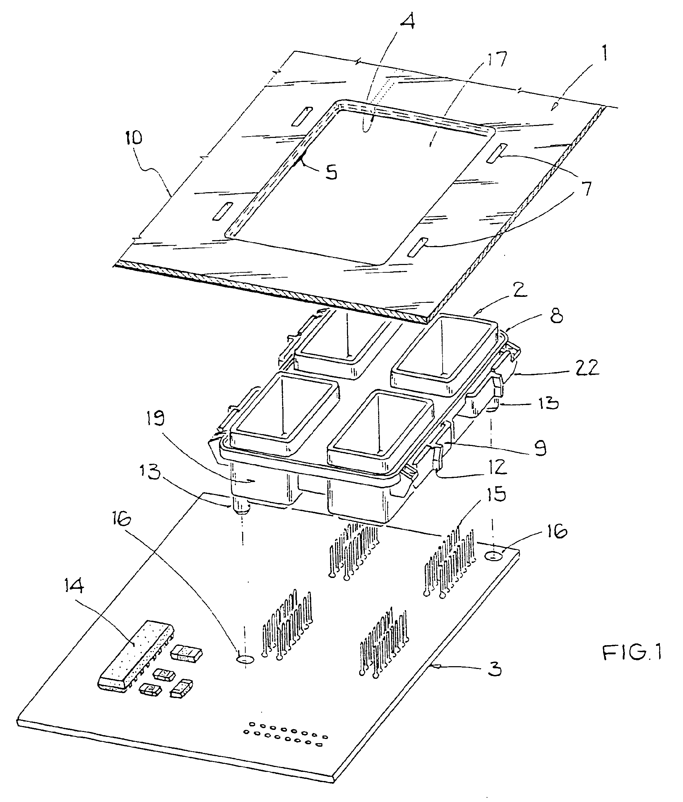

Im Zusammenhang mit der Zeichnung (Figuren 1 bis 4) soll die elektronische Baugruppe anhand eines Ausführungsbeispiels erläutert werden.
- Figur 1: zeigt eine dreidimensionale Ansicht mit einem Ausschnitt der elektronischen Baugruppe,
- Figur 2: zeigt eine dreidimensionale Ansicht mit einem Ausschnitt der elektronischen Baugruppe in verschiedenen Herstellungsschritten,
- Figur 3: zeigt eine Seitenansicht mit einem Ausschnitt der elektronischen Baugruppe vor der Verbindung der Einzelteile,
- Figur 4: zeigt eine Seitenansicht mit einem Ausschnitt der elektronischen Baugruppe nach der Verbindung der Einzelteile.

Die Bauelemente 14 aufweisende Schaltungsanordnung der elektronischen Baugruppe ist von einem bsp. aus zwei Gehäuseteilen 1 zusammengesetzten Kunststoffgehäuse 10 umschlossen, wobei in den Figuren jeweils ein Ausschnitt eines der beiden Gehäuseteile 1 dargestellt ist. Zur elektrichen Kontaktierung der auf dem bsp. als Leiterplatte ausgebildeten Schaltungsträger 3 vorgesehenen Bauelemente 14 der Schaltungsanordnung sind senkrecht zur Leiterplatte 3 mehrere Einpreßstifte ais Kontaktierungselemente 15 angeordnet, bsp. vier Gruppen mit jeweils 16 Einpreßstiften 15, die jeweils in einer Doppelreihe angeordnet sind. Diese Einpreßstifte 15 sollen in Steckerbuchsen 19 zur Bildung eines in einem der Gehäuseteile 1 integrierten Steckeranschlusses 21 eingebracht werden, an den korrespondierende Anschlußstecker extern angeschlossen werden können. Im Gehäuseteil 1 ist zur Aufnahme des Einsatzteils 2 die Aussparung 17 vorgesehen, die von mehreren Freistellungsöfnungen 7 umgeben ist; im Einsatzteil 2 ist zumindest eine, Pindurchbrüche 20 für die Aufnahme der Einpreßstifte 15 aufweisende Steckerbuchse 19 vorgesehen. Bsp. ist zur Bildung des Steckeranschlusses 21 eine Verbindung der vier Gruppen mit jeweils 16 jeweils in einer Doppelreihe angeordneten Einpreßstiften 15 mit der im Einsatzteil 2 integrierten Steckerbuchsengruppe mit vier Steckerbuchsen 19 mit jeweils 16 jeweils in einer Doppelreihe angeordneten Pindurchbrüchen 20 erforderlich.

Das Gehäuseteil 1 besitzt im Bereich des zu bildenden Steckeranschlusses 21 auf seiner Innenseite eine als Kragen ausgebildete, die Aussparung 17 umlaufende Ausformung 4, mehrere (bsp. vier) feste, nicht federnde Rasthaken 5 mit Verrippung 6 sowie Freistellungsöffnungen 7 zur Realisierung der hinterschnittfreien Ausbildung der Rasthaken 5 im Spritzgußwerkzeug (wodurch bewegiiche Schieber im Oberteil des Spritzgußwerkzeugs vermieden werden können).

Das Einsatzteil 2 besitzt eine Steckerbuchsengruppe mit bsp. vier Steckerbuchsen 19 (bsp. mit insgesamt 64 Pindurchbrüchen 20, die den vier Steckerbuchsen 19 der Steckerbuchsengruppe zugeordnet sind), eine mit dem auf der Innenseite des Gehäuseteiles angeordneten Kragen 4 korrespondierende, an der Außenseite bzw. Umrandung umlaufende Nut 8, mittels der aufgrund des verschachtelten Eingreifens des Kragens 4 in die Nut 8 eine Labyrinthdichtung gegen eintretenden Staub gebildet wird und gleichzeitig eine Abstützung des Einsatzteils 2 gegen Zugbelastung beim Kontaktieren der Steckerbuchsen 19 realisiert wird, mehrere mit den Rasthaken 5 des Gehäuseteils 1 korrespondierende, zur Abstützung des Verbunds von Einsatzteil 2 und Gehäuseteil 1 gegen Druckkraftbelastung beim Kontaktieren der Steckerbuchsen 19 bzw. Steckeranschlüsse 21 in einer Richtung senkrecht zur toleranzausgleichenden Ebene, zur Vermeidung von Krafteinwirkungen auf die Leiterplatte 3 dienende Befestigungselemente 22 (bsp. vier Befestigungselemente 22) sowie (bsp. zwei) Zentrierstifte 13 (Fasen) als Zentrierhilfen für die Verbindung des Einsatzteils 2 mit der Leiterplatte 3 bei der Bildung des Steckeranschlusses 21. Zur Gewährleistung eines Toleranzausgleichs bei der Bildung des Steckeranschlusses 21 sind Nut 8 und korrespondierender Kragen 4 als Spielpassung ausgeführt (d.h. die Nut 8 ist mit einem Übermaß beaufschlagt). Die Befestigungselemente 22 werden gemäß dem dargestellten Ausführungsbeispiel durch den Formschluß eines Schnappelements 9 (Schnapphaken) mit einem Vorsprung 11 beim Fügen des Einsatzteils 2 mit dem Gehäuseteil 1 gebildet, wodurch die Aufnahme hoher Druckkraftbelastungen gewährleistet wird; bei Verwendung eines Vorsprungs 11 wird die auf dem Prinzip der Verkürzung der Biegelängen beruhende formschlüssige Verbindung verbessert. Bei geringen Kräften kann eine Aufnahme der Druckkraftbelastung auch alleine durch die Schnappelemente 9 (Schnapphaken) erfolgen, so daß die Befestigungselemente 22 ohne Vorsprung 11 ausgebildet werden können. Alternativ hierzu können die Befestigungselemente 22 in der Art eines Bügels an zwei Punkten fest am Einsatzteil 2 angebunden werden; diese Befestigungselemente 22 können in Richtung des geforderten Toleranzausgleiches starr oder elastisch ausgeführt sein, wobei bei einer starren Ausführung der Befestigungselemente 22 die korrespondierenden Rasthaken 5 des Gehäuseteils 1 elastisch ausgeführt werden. Darüber hinaus können die Befestigungselemente 22 integrierte Dichtungen 10 und Einführhilfen 12 für die Positionierung des Einsatzteils 2 bezüglich der Rasthaken 5 aufweisen.

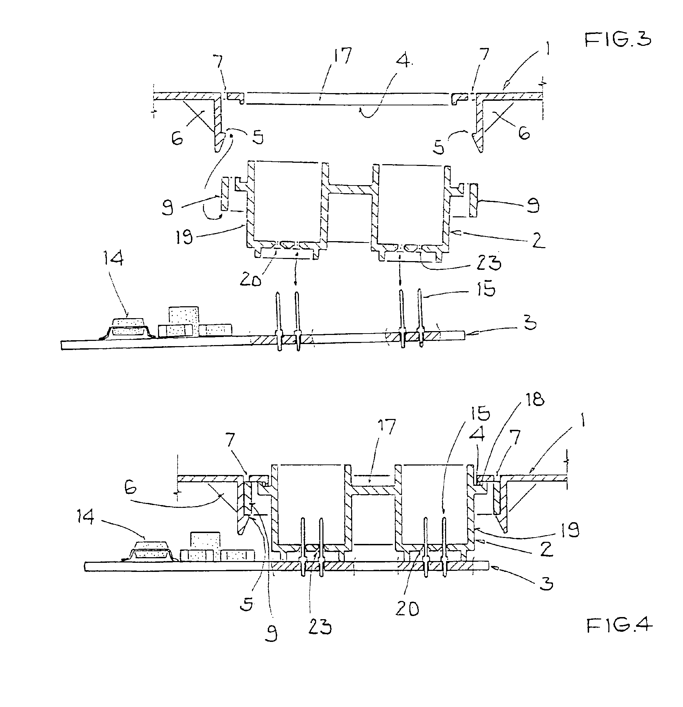

Auf der Leiterplatte 3 sind bsp. 64 Einpreßstifte 15 zur Kontaktierung der Bauelemente 14 (bsp. Widerstände, Transistoren, Kondensatoren etc.) vorgesehen sowie bsp. zwei zu den beiden Zentrierstiften 13 des Einsatzteils 2 korrespondierende Aufnahmebohrungen 16 für die (selbstfindende) Ausrichtung des Einsatzteils 2 bezüglich der Leiterplatte 3 bei der Bildung des Steckeranschlusses 21. Die Pindurchbrüche 20 der Steckerbuchsen 19 weisen Einführschrägen 23 (vgl. hierzu Fig. 3 und Fig. 4) für die Einführung der Einpreßstifte 15 bei der Bildung des Steckeranschlusses 21 auf.

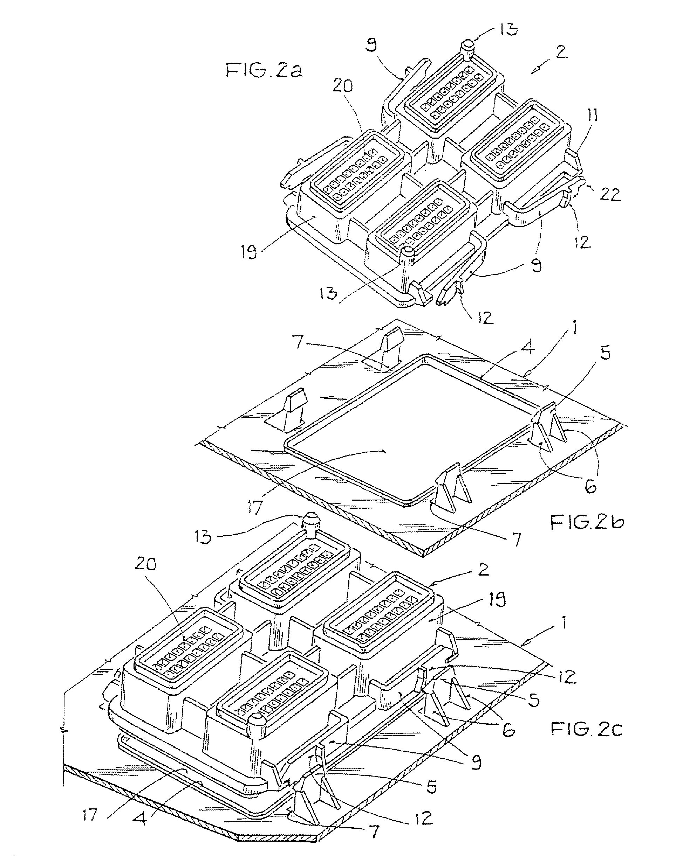

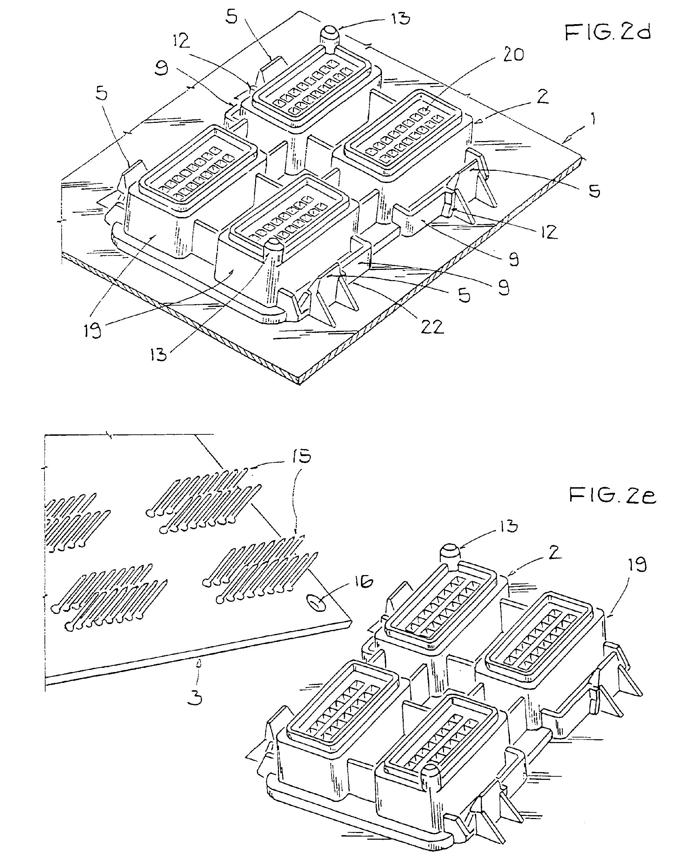

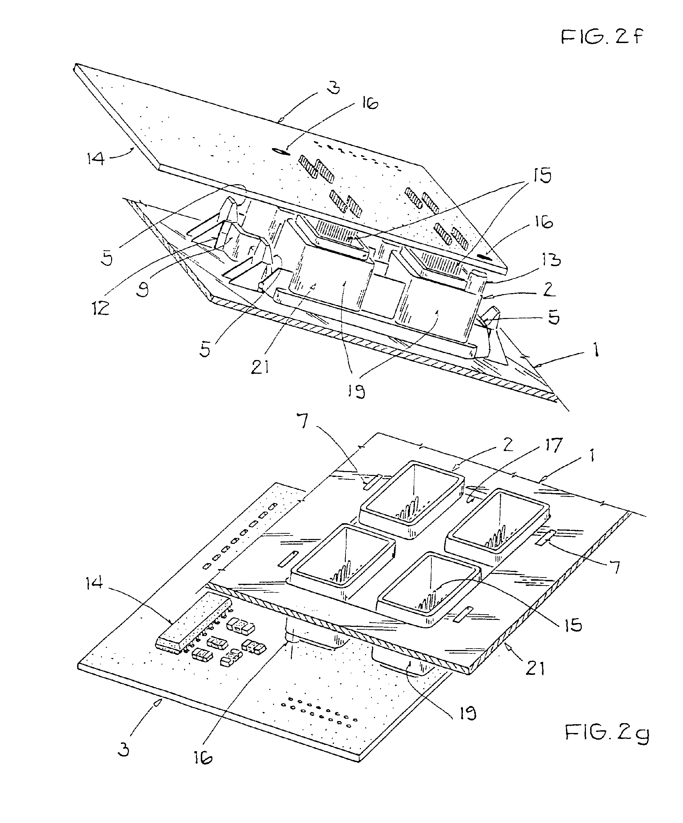

Zur Bildung des Steckeranschlusses 21 sind folgende Verfahrensschritte vorgesehen (vgl. hierzu insbesondere die Figur 2):

Das Einsatzteil 2 mit der vier Steckerbuchsen 19 aufnehmenden Steckerbuchsengruppe (Fig. 2a) wird zum Einbringen in das Gehäuseteil 1 (Fig. 2b) vertikal in Richtung Aussparung 17 des Gehäuseteiles 1 bewegt. Hierbei greifen die Rasthaken 5 auf der Innenseite des Gehäuseteiles 1 frühzeitig in die Einführhilfen 12 der an der Außenseite des Einsatzteils 2 angebrachten Befestigungselemente 22 ein und erleichtern dadurch die selbstfindende Verbindung von Einsatzteil 2 und Gehäuseteil 1; gleichzeitig werden die Schnappelemente 9 des Einsatzteils 2 durch die Rasthaken 5 unter die Vorsprünge 11 des Einsatzteils 2 gedrückt und damit die Befestigungselemente 22 gebildet (Fig. 2c). Beendet wird die Montagebewegung durch das Aufsetzen der auf dem Einsatzteil 2 umlaufenden Nut 8 auf den auf der Innenseite des Gehäuseteils 1 vorgesehenen, die Aussparung 17 umgebenden Kragen 4. Zu diesem Zeitpunkt haben auch die Schnappelemente 9 den Hinterschnitt der Rasthaken 5 passiert und federn soweit zurück, bis diese Rückstellbewegung durch die Rasthaken 5 begrenzt wird. Die Schnappelemente 9 bleiben dabei unter Restspannung; hierdurch wird eine nicht klappernde Verbindung des Einsatzteils 2 mit dem Gehäuseteil 1 gewährleistet (Fig. 2d). Nach der Verbindung von Gehäuseteil 1 und Einsatzteil 2 wird durch das Zusammenspiel von der auf dem Einsatzteil 2 umlaufenden Nut 8 und dem auf der Innenseite des Gehäuseteils 1 vorgesehenen Kragen 4 eine Labyrinthdichtung 18 gebildet (vgl. die Schnittzeichnung der Figur 4). Vorzugsweise ist die Nut 8 breiter als der Kragen 4 ausgeführt, so daß eine Verschiebung des Einsatzteils 2 bezüglich der Aussparung 17 im Gehäuseteil 1 und damit eine Positionierung des Einsatzteils 2 bzw. ein Toleranzausgleich in der Ebene des Gehäusebodens des Gehäuseteils 1, in den das Einsatzteil 2 eingebracht wird, ermöglicht wird; falls der Kragen 4 mittig zur Nut 8 angeordnet ist, kann eine Verschiebung des Einsatzteils 2 bezüglich des Gehäusebodens des Gehäuseteils 1 und damit ein Toleranzausgleich über eine der Hälfte der Differenz zwischen der Breite der Nut 8 und der Breite des Kragens 4 entsprechenden Distanz erfolgen. Wird das Einsatzteil 2 zum Toleranzausgleich quer zur Längsrichtung der Befestigungselemente 22 bewegt, werden einzelne Schnappelemente 9 entspannt bzw. weiter vorgespannt; bei einer Bewegung in Längsrichtung der Befestigungselemente 22 muß die Reibung zwischen den Schnappelementen 9 und den Rasthaken 5 überwunden werden. Hierdurch ist eine klapperfreie Positionierung des Einsatzteils 2 und damit der Stekkerbuchsen 19 der Steckerbucnsengruppe bzw. der Pindurchbrüche 20 der Stekkerbuchsen 19 bezüglich der Einpreßstifte 15 realisierbar. Die zur Vermeidung von Hinterschnitten und der hierdurch bedingten aufwendigen Schieber im Spritzgußwerkzeug im Gehäuseteil 1 vorgesehenen Freislellungsöffnungen 7 werden bei der Verbindung von Gehäuseteil 1 und Einsatzteil 2 durch Teile der Befestigungselemente 22 verschlossen, insbesondere durch die in ihrer Geometrie (Breite, Dicke, Höhe) auf die Freistellungsöffnungen 7 abgestimmten Schnappelemente 9. Nach der Montage von Gehäuseteil 1 und Einsatzteil 2 wird das im Gehäuseteil 1 integrierte Einsatzteil 2 mit der Leiterplatte 3 bzw. den Einpreßstiften 15 auf der Leiterplatte 3 verbunden und hierdurch der Steckeranschluß 21 gebildet (Fig. 2e bis Fig. 2g). Dazu werden die Einpreßstifte 15 unter Zuhilfenahme der in den Pindurchbrüchen 20 vorgesehenen Einführschrägen 23 (vgl. hierzu Fig. 3 und Fig. 4) zentrisch durch die Pindurchbrüche 20 der Steckerbuchsen 19 geschoben. Haben sich Leiterplatte 3 und Einsatzteil 2 weit genug angenähert (Fig. 2f), beginnen die Zentrierstifte 13 des Einsatzteils 2 in die Aufnahmebohrungen 16 der Leiterplatte 3 einzutauchen, wodurch das Einsatzteil 2 unter einer den Toleranzausgleich ermöglichenden Relativbewegung im Gehäuseteil 1 endgültig zur Leiterplatte 3 ausgerichtet wird und damit die Einpreßstifte 15 exakt zu den korrespondierenden Pindurchbrüchen 20 der Steckerbuchsen 19 der Steckerbuchsengruppe positioniert werden (Fig. 2g). An den im Gehäuseteil 1 integrierten Steckeranschluß 21 wird ein korrespondierender externer Anschlußstecker angeschlossen; aufgrund des Formschlusses zwischen Schnappeiement 9 und Vorsprung 11 (Ausbildung des Befestigungselementes 22) und der hierdurch bedingten Steifigkeit in vertikaler Richtung (senkrecht zur Ebene des Gehäuseteils 1) wird, je nachdem in welche Richtung der Formschluß wirkt, eine Zug- oder Druckkraftentlastung realisiert, wodurch die hierbei auftretenden Kontaktierungskräfte durch das Einsatzteil 2 ohne große Biegelängen auf das Gehäuseteil 1 übertragen und nicht die darunterliegende Leiterplatte 3 belasten.

Demzufolge kann eine elektronische Baugrupppe realisiert werden, bei der
- die im Gehäuse bzw. in mindestens einem Gehäuseteil integrierten Steckerbuchsen auf einfache Weise zu einzelnen Steckerbuchsengruppen zusammengefaßt werden können,
- eine Entkopplung dieser Steckerbuchsen bezüglich der Kontaktierungselemente auf dem Schaltungsträger ohne Hinterschnitte im zur Herstellung des Gehäuses bzw. Gehäuseteiles vorgesehenen Werkzeug realisiert werden kann,
- eine spielfreie Verbindung von Einsatzteil und Gehäuse bzw. Gehäuseteil unter Verwendung einer Montagehilfe ermöglicht wird, bei der ein Klappern des Einsatzteils durch Vorspannung der Schnappelemente des Einsatzteils vermieden wird und bei dem die (zur Vermeidung von Hinterschnitten) vorgesehenen Freistellungsöffnungen im Gehäuseteil durch Teile des Einsatzteils abgedichtet werden,
- durch zusätzlich am Einsatzteil angebrachte Zentrierstifte eine Positionierung des im Gehäuse bzw. Gehäuseteil integrierten Einsatzteils auf dem Schaltungsträger zur Bildung des Steckeranschlusses ermöglicht wird.

## Patentansprüche

1. Elektronische Baugruppe mit auf einem Schaltungsträger (3) angeordneten Kontaktierungselementen (15), mit einem den Schaltungsträger (3) umgebenden Gehäuse (10) und mit mindestens einem im Gehäuse (10) integrierten Steckeranschluß (21), wobei in einer Aussparung (17) des Gehäuses (10) ein Pindurchbrüche (20) aufweisendes Einsatzteil (2) beweglich gelagert ist,
und wobei ein Übermaß an der Verbindungsstelle von Einsatzteil (2) und Gehäuse (1) die Pindurchbrüche (20) bei der Verbindung des Einsatzteils (2) mit dem Schaltungsträger (3) zur Bildung des Steckeranschlusses (21) bezüglich der Kontaktierungselemente (15) ausrichtbar sind, **dadurch gekennzeichnet, daß** das Gehäuse (10) auf seiner Innenseite an der Umrandung der Aussparung (17) Rasthaken (5) aufweist, daß das Einsatzteil (2) an seiner Außenseite zu den Rasthaken (5) korrespondierende Befestigungselemente (22) aufweist, und daß bei der Verbindung von Einsatzteil (2) und Gehäuse (10) die Befestigungselemente (22) in die korrespondierenden Rasthaken (5) eingreifen.

2. Elektronische Baugruppe nach einem der Ansprüche 1, **dadurch gekennzeichnet, daß** das Einsatzteil (2) an seiner Berandung eine umlaufende Nut (8) aufweist, daß das Gehäuse (10) eine die Aussparung (17) umgebende Ausformung (4) aufweist, und daß bei der Verbindung von Einsatzteil (2) und Gehäuse (10) die Ausformung (4) in die Nut (8) zur staubdichten Abdichtung des Gehäuse s (10) eingreift.

3. Elektronische Baugruppe nach Anspruch 2, **dadurch gekennzeichnet, daß** die Breite der Nut (8) größer als die Breite der Ausformung (4) gewählt ist, so daß bei der Verbindung des Einsatzteils (2) mit dem Schaltungsträger (3) zur Bildung des Steckeranschlusses (21) die Pindurchbrüche (20) des Einsatzteils (2) bezüglich der Kontaktierungselemente (15) verschiebbar sind.

4. Elektronische Baugruppe nach Anspruch 1, **dadurch gekennzeichnet, daß** die Befestigungselemente (22) des Einsatzteils (2) ein Schnappelement (9), einen Vorsprung (11) sowie eine Einführhilfe (12) zur Positionierung der Befestigungselemente (22) des Einsatzteils (2) bezüglich der Rasthaken (5) des Gehäuses (10) aufweisen.

5. Elektronische Baugruppe nach Anspruch 4, **dadurch gekennzeichnet, daß** durch die Schnappelemente (9) das Einsatzteil (2) bei der Verbindung mit dem Schaltungsträger (3) zur Bildung des Steckeranschlusses (21) in der Ebene des Gehäuses (10) beweglich ist.

6. Elektronische Baugruppe nach Anspruch 4 oder 5, **dadurch gekennzeichnet, daß** durch einen Formschluß zwischen Schnappelement (9) und Vorsprung (11) der Befestigungselemente (22) bei der Verbindung von Einsatzteil (2) und Gehäuse (10) eine Steifigkeit senkrecht zur Ebene des Gehäuses (10) realisiert ist.

7. Elektronische Baugruppe nach einem der Ansprüche 1 bis 6, **dadurch gekennzeichnet, daß** das Gehäuse (10) die Aussparungen (17) umgebende Freistellungsöffnungen (7) aufweist.

8. Elektronische Baugruppe nach Anspruch 7, **dadurch gekennzeichnet, daß** die Befestigungselemente (22) des Einsatzteils (2) bei der Verbindung von Einsatzteil (2) und Gehäuse (10) die Freistellungsöffnungen (7) verschließen.

9. Elektronische Baugruppe nach Anspruch 1, **dadurch gekennzeichnet, daß** das Einsatzteil (2) mindestens eine Steckerbuchse (19) aufweist, in der mehrere Pindurchbrüche (20) zusammengefaßt sind, und daß die mindestens eine Steckerbuchse (19) bei der Verbindung des Einsatzteils (2) mit dem Schaltungsträger (3) zur Bildung des Steckeranschlusses (21) bezüglich der Kontaktierungselemente (15) ausgerichtet wird.

10. Elektronische Baugruppe nach Anspruch 9, **dadurch gekennzeichnet, daß** das Einsatzteil (2) eine Steckerbuchsengruppe mit mindestens zwei Steckerbuchsen (19) aufweist, und daß die Steckerbuchsengruppe bei der Verbindung des Einsatzteils (2) mit dem Schaltungsträger (3) zur Bildung des Steckeranschlusses (21) bezüglich der Kontaktierungselemente (15) ausgerichtet wird.

## Claims

1. An electronic module with contacting elements (15) arranged on a circuit support (3), with a housing (10) surrounding the circuit support (3) and with at least one plug-type connector (21) integrated into the housing (10), wherein an insert (2) having pin openings (20) is movably supported in a recess (17) of the housing (10),
and wherein an overdimension at the connection point between insert (2) and housing (1) enables the pin openings (20) to be aligned in relation to the contacting elements (15) when the insert (2) is connected with the circuit support (3) for the purpose of forming the plug-type connector (21), **characterised in that** the housing (10) has locking hooks (5) on its inner side at the edge of the recess (17), that the insert (2) has fixing elements (22) on its outer side corresponding to the locking hooks (5) and that the fixing elements (22) engage the corresponding locking hooks (5) when insert (2) and housing (10) are connected.

2. An electronic module according to claim 1, **characterised in that** the insert (2) has a circumferential groove (8) along its rim, that the housing (10) has a bulge (4) surrounding the recess (17) and that the bulge (4) engages the groove (8) for dust-tight sealing of the housing (10) when insert (2) and housing (10) are connected.

3. An electronic module according to claim 2, **characterised in that** the width of the groove (8) is selected to be larger than the width of the bulge (4), such that the pin openings (20) of the insert (2) can be shifted in relation to the contacting elements (15) when the insert (2) is connected with the circuit support (3) for the purpose of forming the plug-type connector (21).

4. An electronic module according to claim 1, **characterised in that** the fixing elements (22) of the insert (2) have a snap element (9), a projection (11) and an insertion aid (12) for positioning the fixing elements (22) of the insert (2) in relation to the locking hooks (5) of the housing (10).

5. An electronic module according to claim 4, **characterised in that** the snap elements (9) enable the insert (2) to be movable in the plane of the housing (10) when being connected with the circuit support (3) for the purpose of forming the plug-type connector (21).

6. An electronic module according to claim 4 or 5, **characterised in that**, by a form-fit between snap element (9) and projection (11) of the fixing elements (22), a stiffness perpendicular to the plane of the housing (10) is realized when insert (2) and housing (10) are connected.

7. An electronic module according to any one of claim 1 to 6, **characterised in that** the housing (10) has exemption openings (7) surrounding the recess (17).

8. An electronic module according to claim 7, **characterised in that** the fixing elements (22) of the insert (2) close the exemption openings (7) when insert (2) and housing (10) are connected.

9. An electronic module according to claim 1, **characterised in that** the insert (2) has at least one female plug (19) in which multiple pin openings (20) are combined and that the at least one female plug (19) is aligned in relation to the contacting elements (15) when the insert (2) is connected with the circuit support (3) for the purpose of forming the plug-type connector (21).

10. An electronic module according to claim 9, **characterised in that** the insert (2) has a group of female plugs with at least two female plugs (19) and that the group of female plugs is aligned in relation to the contacting elements (15) when the insert (2) is connected with the circuit support (3) for the purpose of forming the plug-type connector (21).

## Revendications

1. Sous-ensemble électronique avec des éléments de contact (15) disposés sur un support de circuit (3), avec un boîtier (10) entourant le support de circuit (3) et avec au moins une connexion par fiche (21) intégrée dans le boîtier (10), une pièce d'insertion (2) présentant des traversées de broche (20) étant supportée de façon mobile dans un évidement (17) du boîtier (10),
et les traversées de broche (20) lors du raccordement de la pièce d'insertion (2) et du support de circuit (3) pour la formation de la connexion par fiche (21) par rapport aux éléments de contact (15) pouvant être alignées par une surdimension au niveau de l'emplacement de raccordement de la pièce d'insertion (2) et du boîtier (1), **caractérisé en ce que** le boîtier (10), sur son côté intérieur sur la bordure de l'évidement (17), présente des crochets d'encliquetage (5), **en ce que** la pièce d'insertion (2), sur son côté extérieur, présente des éléments de fixation (22) correspondant aux crochets d'encliquetage (5), et **en ce que**, lors du raccordement de la pièce d'insertion (2) et du boîtier (10), les éléments de fixation (22) engrènent dans les crochets d'encliquetage (5) correspondants.

2. Sous-ensemble électronique selon la revendication 1, **caractérisé en ce que** la pièce d'insertion (2), au niveau de sa délimitation, présente une rainure (8) périphérique, **en ce que** le boîtier (10) présente une formation (4) entourant l'évidement (17), et **en ce que**, lors du raccordement de la pièce d'insertion (2) et du boîtier (10), la formation (4) engrène dans la rainure (8) pour réaliser une étanchéité à la poussière du boîtier (10).

3. Sous-ensemble électronique selon la revendication 2, **caractérisé en ce que** la largeur de la rainure (8) est choisie plus grande que la largeur de la formation (4), de sorte que, lors du raccordement de la pièce d'insertion (2) et du support de circuit (3) pour la formation de la connexion par fiche (21), les traversées de broche (20) de la pièce d'insertion (2) peuvent être déplacées par rapport aux éléments de contact (15).

4. Sous-ensemble électronique selon la revendication 1, **caractérisé en ce que** les éléments de fixation (22) de la pièce d'insertion (2) présentent un élément à déclic (9), une saillie (11) ainsi qu'une aide à l'introduction (12) pour le positionnement des éléments de fixation (22) de la pièce d'insertion (2) par rapport aux crochets d'encliquetage (5) du boîtier (10).

5. Sous-ensemble électronique selon la revendication 4, **caractérisé en ce que** la pièce d'insertion (2) est mobile dans le plan du boîtier (10) grâce aux éléments à déclic (9) lors du raccordement avec le support de circuit (3) pour la formation de la connexion par fiche (21).

6. Sous-ensemble électronique selon la revendication 4 ou la revendication 5, **caractérisé en ce que**, par une liaison de forme entre l'élément à déclic (9) et la saillie (11) des éléments de fixation (22), lors du raccordement de la pièce d'insertion (2) et du boîtier (10), il est réalisé une rigidité perpendiculairement au plan du boîtier (10).

7. Sous-ensemble électronique selon une des revendications 1 à 6, **caractérisé en ce que** le boîtier (10) présente des ouvertures de libération (7) entourant les logements (17).

8. Sous-ensemble électronique selon la revendication 7, **caractérisé en ce que** les éléments de fixation (22) de la pièce d'insertion (2) ferment les ouvertures de libération (7) lors du raccordement de la pièce d'insertion (2) et du boîtier (10).

9. Sous-ensemble électronique selon la revendication 1, **caractérisé en ce que** la pièce d'insertion (2) présente au moins un alvéole (19) dans lequel plusieurs traversées de broche (20) sont réunies, et **en ce que** l'alvéole (19) au moins au nombre de un est, lors du raccordement de la pièce d'insertion (2) et du support de circuit (3) pour la formation de la connexion par fiche (21), aligné par rapport aux éléments de contact (15).

10. Sous-ensemble électronique selon la revendication 9, **caractérisé en ce que** la pièce d'insertion (2) présente un groupe d'alvéoles avec au moins deux alvéoles (19), et **en ce que** le groupe d'alvéoles est, lors du raccordement de la pièce d'insertion (2) et du support de circuit (3) pour la formation de la connexion par fiche (21), aligné par rapport aux éléments de contact (15).
